# EUROPÄISCHE PATENTANMELDUNG

(11) **EP 2 474 370 A1**
(43) Veröffentlichungstag der Anmeldung: **11.07.2012**
(21) Anmeldenummer: 12002507.7
(22) Anmeldetag: 19.12.2008
(51) Int. Cl.: B05D 7/24, C23C 16/448, C23C 16/52

(54) **Verfahren und Vorrichtung zur Herstellung von Prozessgasen für die Dampfphasenabscheidung**

(30) Priorität: 21.12.2007 DE 102007062977
(62) Teilanmeldung aus: 08022113.8
(71) Anmelder: Schott AG, 55122 Mainz (DE)
(72) Erfinder: Haines, Dan, Lake Ariel, PA 18436 (US); Bicker, Matthias, Dr., 55126 Mainz (DE); Bauer, Stefan, Dr., 55232 Alzey (DE); Lohmeyer, Manfred, 55299 Nackenheim (DE)
(74) Vertreter: Herden, Andreas F.

(57) **Zusammenfassung**

Die Erfindung betrifft ein Verfahren zur Herstellung von Schichten auf Werkstücken (30), bei dem wenigstens eine Komponente zur Herstellung der Schicht dosiert wird, wobei sich diese Komponente während der Dosierung in einer flüssigen Phase befindet und in einem nachfolgenden Prozessschritt zumindest teilweise in einen anderen Aggregatzustand überführt wird.

## Beschreibung

Die Erfindung betrifft allgemein die Abscheidung von funktionellen Schichten auf Substraten. Insbesondere betrifft die Erfindung die chemische Dampfphasenabscheidung und die Dosierung der zur Dampfphasenabscheidung verwendeten Stoffe.

Aus der US 2001/0004470 A1 sind Alkan- und Polyamin-Lösungsmittelzusammensetzungen bekannt. Die Lösungsmittelzusammensetzung dient der Flüssigzufuhr von metallorganischen Precursor-Substanzen für die chemische Dampfphasenabscheidung, um beispielsweise sogenannte SBT-Schichten (SrBi₂Ta₂O₉ -Schichten) für Datenspeicher abzuscheiden. Um den Precursor in die Gasphase zu überführen, wird Flash-Verdampfung eingesetzt. Bei diesem Verfahren erfolgt eine teilweise Verdampfung durch eine Druckreduzierung.

Die DE 199 60 333 A1 beschreibt eine Vorrichtung zum Herstellen eines Gasgemisches aus HMDSO (Hexamethyldisiloxan) und Sauerstoff als Prozessgas zur Plasmabeschichtung. Dazu sind in einer länglichen, vertikal angeordneten, kühlbaren Kolonne mehrere Füllpackungen übereinander angeordnet. Im oberen Bereich der Kolonne sind ein von außen in die Kolonne eingeführter Zulaufstutzen und ein Gasaustrittsanschluss angeordnet. Weiterhin sind Einrichtungen für die Messung der Temperatur, des Drucks und der austretenden Gasmenge vorgesehen.

Die US 2005/0115501 A1 zeigt eine Vorrichtung zur Bearbeitung von dünnen Schichten unter Verwendung einer verdampften Flüssigkeit. Die Vorrichtung ist in der Lage, die Genauigkeit der Durchflusssteuerung von Einrichtungen zur Steuerung des Durchflusses zu sichern. Hierbei werden die Einrichtungen zur Durchflussteuerung nicht vom Leitungssystem getrennt. Die Vorrichtung umfasst eine Umgehung eines Teil eines Durchlauf für eine Waschflüssigkeit. In die Umgehung ist ein Durchflussmessgerät integriert. Die Flüssigkeit kann nach dem Durchflussmessgerät eine Steuerung der Durchflussmenge durchfließen. Der vom Durchflussmessgerät gemessene Wert wird mit einem in der Steuerung der Durchflussmenge gesetzten Wert verglichen werden. Auf diese Weise kann festgestellt werden, ob die Steuerung korrekt arbeitet oder nicht.

Die EP 1 122 335 A1 beschreibt Verfahren und eine Vorrichtung zur Verdampfung von Flüssigkeiten. Die Vorrichtung ist ein System zur chemischen Abscheidung von Dampf und umfasst eine Abscheidungskammer und einen an diese Kammer gekoppelten Verdampfer. In einem Aspekt weist der Verdampfer eine vergleichsweise kurze Durchflussstrecke auf, um ein Trägergas mit einem flüssigen precursor zu vermischen, um eine fein verteilte aerosolartige Dispersion zu erzeugen, die mittels einer heißen Platte verdampft wird.

Das Technical Disclosure Bulletin XP 000124375 der IBM zeigt ein anpassungsfähiges Abgabesystem für chemische Dämpfe. Es besteht beispielsweise aus drei Einrichtungselementen: Einem Durchflussmessgerät, einen Verdampfer sowie eine kurze beheizbare Strecke.

Die US 6,110,531 zeigt ein Verfahren und eine Vorrichtung zur Erstellung dünner Schichten für integrierte Schaltungen mittels chemischer Dampfabscheidung.

Ein weiteres bisher eingesetztes System zur Verdampfung von Precursoren ist ein sogenannter Bubbler. Bei diesem System wird das Trägergas in den flüssigen Precursor eingeblasen. Der Precursor verdampft dabei in die Gasblasen hinein und wird mit dem Trägergas weitertransportiert.

Es zeigt sich in der Praxis, dass Bubbler hinsichtlich des Precursor-Flusses jedoch schwierig produktionsstabil einzustellen sind, da Druck, Temperatur, und Precursor-Gasfluss gleichzeitig großen Einfluss auf die Verdampfungsrate haben. Beispielsweise kann eine nur kleine Änderung der Blasengröße aufgrund der damit einhergehenden Änderung der zur Verfügung stehenden Verdampfungsoberfläche bereits großen Einfluss auf die Precursor-Konzentration haben. Auch bei den anderen aus dem Stand der Technik bekannten Verdampfern ist dies der Fall. So hängt bei einer Kolonne, wie sie die DE 199 60 333 A1 vorschlägt, der Precursor-Gehalt des Prozessgases empfindlich von der Temperatur der Kolonne ab. Auch der in der Kolonne herrschende Druck fließt hier ebenso ein, wie bei der Flash-Verdampfung.

Der Erfindung liegt daher die Aufgabe zugrunde, eine besser kontrollierbare Dosierung von Precursor-Substanzen für die chemische Dampfphasenabscheidung bereitzustellen, die weniger anfällig ist gegenüber Schwankungen von Prozessparametern. Die erfindungsgemäße Lösung dieser Aufgabe ist in den unabhängigen Ansprüchen dargelegt. Vorteilhafte Ausgestaltungen und Weiterbildungen der Erfindung sind Gegenstand der Unteransprüche.

Demgemäß sieht die Erfindung ein Verfahren zur Herstellung von Schichten auf Werkstücken vor, bei dem wenigstens eine Komponente zur Herstellung der Schicht, insbesondere eine schichtbildende Komponente dosiert wird, wobei sich diese Komponente während der Dosierung in einer flüssigen Phase befindet und in einem nachfolgenden Prozessschritt zumindest teilweise in einen anderen Aggregatzustand überführt wird. Die Schicht wird dabei aus der sich im anderen Aggregatzustand befindlichen Komponente hergestellt. Als andere Aggregatzustände kommen insbesondere die Gasphase und ein Plasma in Betracht.

Die Erfindung ist dabei besonders für verschiedene chemische Dampfphasenabscheide-Verfahren (CV-Verfahren) geeignet. Neben einer chemischen Dampfphasenabscheidung im Vakuum oder unter Niederdruck-Bedingungen können auch Atmosphärendruck-CVD-Verfahren, wie etwa thermische CVD unter Atmosphärendruck oder Atmosphärendruck-Plasmaabscheidung eingesetzt werden. Weitere Verfahren sind Flammpyrolyse oder sogenannte "Combustion CVD" (CCVD, Verbrennungs-CVD).

Insbesondere sieht die Erfindung dazu ein Verfahren zur Dampfphasenabscheidung von Schichten auf Werkstücken vor, wobei
- ein Flüssigkeitsreservoir mit einer flüssigen ersten Prozessgaskomponente bereitgestellt, und
- die flüssige Prozessgaskomponente über eine Dosiereinrichtung in einen Verdampfer (2) geleitet wird, wobei
- die flüssige erste Prozessgaskomponente (34) im Verdampfer verdampft und in die Gasphase überführt wird, und einem Reaktor (20) zugeführt wird, und wobei
- mittels einer Energiequelle eine reaktive Zone mit der ersten Prozessgaskomponente im gefüllten Bereich des Reaktors erzeugt wird, wobei
- mit den sich in der reaktiven Zone bildenden Reaktionsprodukten der ersten Prozessgaskomponente eine Beschichtung auf dem Werkstück abgeschieden wird. Dabei wird der Massenfluss der ersten Prozessgaskomponente in den Reaktor hinein mittels einer auf die Dosiereinrichtung wirkenden Regeleinrichtung durch eine Regelung des Flusses der flüssigen Prozessgaskomponente in den Verdampfer gesteuert. Hierbei wird der Fluss der flüssigen Prozessgaskomponente in deren Zuleitung zum Verdampfer mit einem Massenflusssensor gemessen, der zwei entlang der Flussrichtung in der Zuleitung angeordnete Temperaturfühler umfasst, mit denen ein Temperaturgradient in der flüssigen Prozessgaskomponente gemessen wird.

In besonders bevorzugter Weiterbildung ist dabei ein Verfahren zur chemischen Dampfphasenabscheidung, vorzugsweise zur plasmaunterstützten chemischen Dampfphasenabscheidung von Schichten auf Werkstücken vorgesehen. Dazu wird
- ein Flüssigkeitsreservoir mit einer flüssigen ersten Prozessgaskomponente bereitgestellt, und
- die flüssige Prozessgaskomponente in einen Verdampfer geleitet, wobei
- die flüssige erste Prozessgaskomponente im Verdampfer verdampft und in die Gasphase überführt wird, und wobei
- ein Reaktor mit einem zu beschichtenden Werkstück mittels einer Pumpe evakuiert,
- die gasförmige erste Prozessgaskomponente dem evakuierten Bereich des Reaktor zugeführt, und
- mittels eines elektromagnetischen Feldes ein Plasma im evakuierten, mit der ersten Prozessgaskomponente gefüllten Bereich des Reaktors gezündet wird, wobei
- mit den sich im Plasma bildenden Reaktionsprodukten der ersten Prozessgaskomponente eine Beschichtung auf dem Werkstück abgeschieden wird. Dabei wird der Massenfluss der ersten Prozessgaskomponente in den Reaktor hinein wiederum mittels der Regeleinrichtung durch eine Regelung des Flusses der flüssigen Prozessgaskomponente in den Verdampfer gesteuert. Bei dieser Ausführungsform wird eine reaktive Zone demgemäß in Form eines Plasmas erzeugt. Die Erfindung kann aber durchaus auch für andere Arten von reaktiven Zonen eingesetzt werden. Denkbar ist beispielsweise eine Abscheidung durch thermische CVD. Hierbei wird eine erhitzte Zone erzeugt, in welcher sich die Reaktionsprodukte bilden. Unter eine Vakuumabscheidung fällt als Anwendungsgebiet der Erfindung nicht nur CVD, sondern auch reaktive PVD. Hierzu wird eine Schicht aufgedampft oder gesputtert, wobei zumindest ein Precursor, beziehungsweise eine erste Komponente der Vakuum-, oder Niederdruck-Umgebung zugeführt wird.

Die Erfindung ist nicht auf bestimmte Werkstücke beschränkt. Es können sowohl flächenförmige, als auch voluminöse Werkstücke, insbesondere auch Hohlkörper beschichtet werden. Im letzteren Fall ist insbesondere auch an eine Innenbeschichtung gedacht.

Im Falle einer Vakuumabscheidung, wie insbesondere bei einer chemischen Dampfphasenabscheidung unter Niederdruck- oder Vakuumbedingungen muss nicht in allen Fällen der gesamte Reaktor evakuiert werden. Wird beispielsweise nur die Innenseite eines hohlkörperförmigen Werkstücks beschichtet, kann das Werkstück im Reaktor gasdicht an die Pumpe und die Zuleitung angeschlossen und innenseitig evakuiert werden. Die Umgebung kann gegebenenfalls auf Normaldruck verbleiben, oder auch gesondert evakuiert werden.

Es hat sich gezeigt, dass eine genaue Dosierung auch sehr kleiner Massenflüsse in flüssiger Form möglich ist. Der durch die Dosierung eingestellte Massenfluss der flüssigen Prozessgaskomponente liegt dabei gemäß einer Weiterbildung der Erfindung im Bereich von 0,0005 bis 2000 g/h, vorzugsweise im Bereich von 0,05 g/h bis 50 g/h, besonders bevorzugt im Bereich von 0,1 g/h bis 20 g/h. Dies ist insbesondere dann wichtig, wenn aus der Gasphase und/oder einem Plasma abgeschieden wird. Durch die Überführung in die Gasphase entsteht eine hohe Volumenzunahme. Ungenauigkeiten im Massenfluss der flüssigen Komponente werden demnach beim Massenfluss der gasförmigen Komponente erheblich verstärkt. Es hat sich demgegenüber aber gezeigt, dass der Massenfluss einer gasförmigen Komponente mittels der Erfindung sogar sehr genau und stabil regeln lässt. Der Massenfluss kann äquivalent auch als Volumenstrom geregelt werden. Vorteilhafte Bereiche des Volumenstroms der flüssigen Komponente liegen dabei im Bereich von 5 Nanolitern pro Minute bis 1000 Mikrolitern pro Minute, vorzugsweise im Bereich von 10 Nanolitern pro Minute bis 100 Mikrolitern pro Minute, besonders bevorzugt im Bereich von 20 Nanolitern pro Minute bis 10 Mikrolitern pro Minute.

Um die gewünschte Dosiergenauigkeit der in den anderen Aggregatzustand, insbesondere in den gasförmigen Zustand überführten Komponente zu erreichen, ist gemäß noch einer Weiterbildung der Erfindung dabei insbesondere eine Dosiergenauigkeit des Flüssigkeitsvolumenstroms im Bereich unterhalb von 30pl/min, vorzugsweise im Bereich unterhalb von 3µl/min, besonders bevorzugt unterhalb von 0,3µl/min vorgesehen.

Besonders bevorzugt wird weiterhin im Falle einer Plasmaabscheidung ein gepulstes Plasma zur Abscheidung verwendet.

Die entsprechende erfindungsgemäße Vorrichtung zur Durchführung des Verfahrens, beziehungsweise zur Abscheidung von Schichten auf Werkstücken umfasst entsprechend
- ein Flüssigkeitsreservoir für eine flüssige erste Prozessgaskomponente,
   eine Dosiereinrichtung,
- einen Verdampfer,
- eine Leitung, um die flüssige Prozessgaskomponente (34) in den Verdampfer zu leiten,
- ein Reaktor, ausgebildet zur Aufnahme eines zu beschichtenden Werkstücks,
- eine am Reaktor angeschlossene Gasabführung, über die flüchtige Zersetzungsprodukte aus dem Beschichtungsbereich des Reaktors entfernt werden können,
- eine Zuleitung, um die im Verdampfer verdampfte gasförmige erste Prozessgaskomponente dem Reaktor zuzuführen, und
- eine Energiequelle welche an den Reaktor angeschlossen ist, um eine reaktive Zone im mit der ersten Prozessgaskomponente gefüllten Bereich des Reaktors zu erzeugen, so dass mit den sich in der reaktiven Zone bildenden Reaktionsprodukten der ersten

Prozessgaskomponente eine Beschichtung auf dem Werkstück abgeschieden wird, sowie eine Regeleinrichtung zur Regelung des Massenflusses der ersten Prozessgaskomponente in den Reaktor hinein, wobei die Regeleinrichtung dazu ausgebildet ist, zur Einstellung des Massenflusses den Fluss der flüssigen Prozessgaskomponente in den Verdampfer über die Dosiereinrichtung zu regeln. Hierbei ist in der Zuleitung zum Verdampfer ein Massenflusssensor angeordnet, der zwei entlang der Flussrichtung in der Zuleitung angeordnete Temperaturfühler umfasst, mit denen ein Temperaturgradient in der flüssigen Prozessgaskomponente gemessen wird.

Auch die Energiequelle kann vorteilhaft mittels einer Regeleinrichtung oder einer weiteren Regel- oder Steuereinrichtung regelbar sein.

Im Falle einer Vorrichtung zur plasmaunterstützten Dampfphasenabscheidung von Schichten auf Werkstücken ist dementsprechend
- ein Flüssigkeitsreservoir für eine flüssige erste Prozessgaskomponente,
- ein Verdampfer,
- eine Leitung, um die flüssige Prozessgaskomponente in den Verdampfer zu leiten,
- ein Reaktor, ausgebildet zur Aufnahme eines zu beschichtenden Werkstücks,
- eine am Reaktor angeschlossene Pumpe, um den Beschichtungsbereich des Reaktors zu evakuieren,
- eine Zuleitung, um die im Verdampfer verdampfte gasförmige erste Prozessgaskomponente dem Reaktor zuzuführen, und
- eine Quelle für elektromagnetische Felder vorgesehen, welche an den Reaktor angeschlossen ist, um mittels des von der Quelle erzeugten elektromagnetischen Feldes ein Plasma im evakuierten, mit der ersten Prozessgaskomponente gefüllten Bereich des Reaktors zu zünden, so dass mit den sich im Plasma bildenden Reaktionsprodukten der ersten Prozessgaskomponente eine Beschichtung auf dem Werkstück abgeschieden wird. Es ist wiederum eine Regeleinrichtung zur Regelung des Massenflusses der ersten

Prozessgaskomponente in den Reaktor hinein vorhanden, die dazu ausgebildet ist, zur Einstellung des Massenflusses den Fluss der flüssigen Prozessgaskomponente in den Verdampfer zu regeln.

Unter einer Quelle für elektromagnetische Felder wird auch eine Quelle für elektrostatische Felder verstanden. Diese kann beispielsweise zur Schichtabscheidung mittels eines Plasmas einer Glimmentladung eingesetzt werden.

Neben plasmaunterstützter chemischer Dampfphasenabscheidung kann die Erfindung aber auch für andere Arten von chemischer Dampfphasenabscheidung, also allgemein für CVD eingesetzt werden. Je nach Abscheideprozess kann dementsprechend auch die Quelle für elektromagnetische Felder entfallen. Als Beispiel genannt sei hier thermische CVD.

Um einen Fluss der flüssigen ersten Prozessgaskomponente durch die Leitung in den Verdampfer zu erzeugen, kann eine Fluidfördereinrichtung, wie etwa eine Pumpe oder ein mit Druck beaufschlagtes Reservoir vorgesehen sein. Im letzteren Fall kann in das Reservoir beispielsweise zusätzlich zur flüssigen Prozessgaskomponente ein Gas eingefüllt werden, so dass das Reservoir unter Überdruck relativ zum Verdampfer steht. Dies ist beispielsweise auch dann der Fall, wenn im Verdampfer ein Unterdruck erzeugt oder aufrechterhalten wird. In diesem Fall wird -ein hinreichender Unterdruck vorausgesetzt- die erste Prozessgaskomponente auch dann in den Verdampfer gefördert, wenn das Reservoir unter Normaldruck gehalten ist. Noch eine Möglichkeit ist es, den aufgrund der Schwerkraft und der Anordnung des Reservoirs relativ zum Verdampfer entstehenden hydrostatischen Druck auszunutzen. Dazu ist der Flüssigkeitspegel im Reservoir oberhalb des Eintrittspunkts der Leitung in den Verdampfer angeordnet.

Erfindungsgemäß ist demgemäß ein Flüssigkeits-Dosiersystem für eine kontrollierte Dosierung organischer und/oder metallorganischer Precursor-Substanzen vorgesehen.

Überraschend ist, dass die erfindungsgemäße Flüssigdosierung eine sehr exakte, reproduzierbare Kontrolle des Massenflusses und damit einhergehend auch der Eigenschaften der abgeschiedenen Schichten ermöglicht. An sich sollte man erwarten, dass sich eine Flüssigkeit vor der Verdampfung schlechter dosieren lässt, da mit der Verdampfung eine starke Volumenzunahme einhergeht. Die Dosierung der Flüssigkeit erfordert daher bei vergleichbarer Genauigkeit wesentlich kleinere Absolutfehler.

Es hat sich aber gezeigt, dass die Abscheidung von Schichten mit dem erfindungsgemäßen Verfahren sehr präzise geregelt werden kann. Die Schwankungen des Massenflusses des oder der Prozessgaskomponenten ist sehr gering, was sich auch anhand der abgeschiedenen Schichten nachweisen lässt. So zeigen die Schichten eine niedrige Lichtstreuung und alle Schichteigenschaften erwiesen sich als präzise reproduzierbar.

Das erfindungsgemäße Verfahren stellt gegenüber den bisher üblicherweise verwendeten Bubblern einen sehr einfachen Weg zur Plasmabeschichtung, beziehungsweise der Vorbereitung der verwendeten Precursor-Gase dar. Durch den einfachen Aufbau ist das erfindungsgemäße System auch kostengünstiger als beispielsweise Anlagen mit Bubblern als Gaserzeuger.

Um eine schnelle Verdampfung der ersten Prozessgaskomponente zu erreichen, ist es besonders von Vorteil, wenn die flüssige erste Prozessgaskomponente mit einer Düse im Verdampfer versprüht wird. Allgemein kann die Verdampfungsrate der flüssigen Prozessgaskomponente im Verdampfer höher eingestellt werden, als der Zufluss der flüssigen Prozessgaskomponente. Damit wird vermieden, dass sich größere Mengen von flüssigem Material im Verdampfer ansammeln. Der Verdampfer wird also im Unterschied etwa zu einem Bubbler gewissermaßen "trocken" betrieben. Dadurch, dass das in den Verdampfer eingeführte flüssige Material sehr schnell verdampft wird, ergibt sich eine direkte Einflussnahme einer Änderung des Flusses in der Zuleitung auf den Massenfluss des gasförmigen Precursors in den Verdampfer hinein, so dass eine nahezu verzögerungsfreie Regelung über die Flüssigdosierung ermöglicht wird. Bevorzugt wird die erste Prozessgaskomponente mit wenigstens einer zweiten Prozessgaskomponente zu einem Prozessgasgemisch gemischt. Besonders geeignet sind dabei Inertgase, wie insbesondere Edelgase. Solche Gase erleichtern unter anderem die Zündung des Plasmas und erlauben eine Aufrechterhaltung des Plasmas bei niedrigeren Precursor-Konzentrationen. Alternativ kann aber auch Stickstoff als Inertgas verwendet werden. Alternativ oder zusätzlich kann auch ein Reaktivgas wie beispielsweise Sauerstoff, Ozon, Wasserstoff, Ammoniak oder ein Kohlenwasserstoff verwendet werden.

Es erweist sich dabei außerdem als besonders vorteilhaft, wenn die Mischung der ersten und der zweiten Prozessgaskomponente im Verdampfer erfolgt. Dazu ist eine Zuleitung zum Verdampfer für eine im Reservoir vorgehaltene zweite Prozessgaskomponente vorgesehen, um die erste und die zweite Prozessgaskomponente im Verdampfer zu einem Prozessgasgemisch zu mischen. Die Mischung bereits im Verdampfer erweist sich als günstig zur Vermeidung oder Verminderung von Schwankungen im Massenfluss des verdampften Precursors, die durch einzelne verdampfende Tropfen entstehen können.

Um den Fluss der flüssigen ersten Prozessgaskomponente zu regeln, wird mittels einer geeigneten Einrichtung der momentane Fluss bestimmt. Der Fluss geht dann als Größe in den von der Regeleinrichtung gesteuerten Regelprozess ein. Bevorzugt wird dazu der Fluss der flüssigen Prozessgaskomponente in deren Zuleitung zum Verdampfer mit einem Massenflusssensor gemessen. Dieser ist in der Zuleitung der flüssigen ersten Prozessgaskomponente zum Verdampfer angeordnet und an die Regeleinrichtung angeschlossen.

Die flüssig dosierte Komponente muss gemäß noch einer Weiterbildung der Erfindung nicht rein sein. Vielmehr ist auch daran gedacht, ein Gemisch aus wenigstens zwei Komponenten flüssig zu dosieren. Bei der Verdampfung eines Gemischs mit einem Bubbler hängt die Konzentration der Bestandteile von deren Dampfdruck ab. Demgegenüber ist mittels der Erfindung aufgrund der schnellen und vollständigen Verdampfung der Komponenten im Verdampfer bei einem Gemisch das Mengenverhältnis praktisch nicht vom Dampfdruck abhängig, sofern sich keine größeren Flüssigkeitsmengen im Verdampfer ansammeln.

Ein geeignetes Messprinzip ist die Messung des Massenflusses anhand des Wärmetransports durch die Flüssigkeit. Sensoren dieses Typs sind beispielsweise aus der DE 2350848 A bekannt. Insbesondere kann zwischen zwei entlang der Flussrichtung der flüssigen ersten Prozessgaskomponente beanstandeten Messpunkten die Temperaturdifferenz bestimmt werden. Dazu sind zwei entlang der Flussrichtung der flüssigen ersten Prozessgaskomponente beanstandete Temperaturmessfühler vorgesehen, mit welchen eine Temperaturdifferenz bestimmt wird. Je größer die Temperaturdifferenz, desto höher ist auch der Massenfluss. Zusätzlich ist eine Einrichtung zur Temperaturänderung vorgesehen, um einen Temperaturgradienten in der strömenden Flüssigkeit zu erzeugen. Im einfachsten Fall kann dazu die Flüssigkeit an einem Heizelement vorbeifließen. Die Heizeinrichtung kann auch einen oder beide Temperaturmessfühler selbst beheizen. Beispielsweise kann ein stromdurchflossenes Widerstands- oder Thermoelement als Temperatursensor eingesetzt werden, mit welchem gleichzeitig die Temperatur gemessen und die Flüssigkeit aufgeheizt wird.

Der Druck im Reaktor während der Beschichtung wird gemäß einer bevorzugten Weiterbildung der Erfindung mittels einer Drossel in der Ableitung vom Reaktor zur Pumpe geregelt, die mit der Regeleinrichtung kommuniziert, beziehungsweise an die Regeleinrichtung angeschlossen und so durch die Regeleinrichtung gesteuert werden kann. Demgemäß ist die Regeleinrichtung dazu ausgebildet, den Druck im Reaktor mittels der Drossel zu regeln.

Eine Regelung der im Reaktor vorhandenen Prozessgas-Menge kann dann durch Regelung des Drucks einerseits und einer Regelung des Massenflusses durch die erfindungsgemäße Flüssigdosierung andererseits erfolgen. Eine geregelte Drosselung der Prozessgasmenge zwischen Reaktor und Verdampfer ist dann nicht erforderlich.

Mittels der Erfindung können vielfältige funktionelle Beschichtungen auf flachen und dreidimensional geformten, beziehungsweise ausgeformten Substraten hergestellt werden. Ein besonderer Vorzug ist die sehr gute Eignung für die Herstellung von funktionellen Beschichtungen aus Precursor-Substanzen mit niedrigem Dampfdruck. Mit dem Verfahren können im einem produktionstauglichen Prozess erste Prozessgaskomponenten verdampft und dem Reaktor zugeführt werden, die bei Raumtemperatur einen Dampfdruck von kleiner als 200mbar, vorzugsweise kleiner als 80mbar, besonders bevorzugt kleiner als 10mBar aufweist. Auch gilt dies für solche Komponenten, die bei einer Temperatur von 130°C einen Dampfdruck von kleiner als 10000mbar, vorzugsweise kleiner als 1300mbar, besonders bevorzugt kleiner als 50mbar aufweisen.

Die Erfindung stellt eine sehr effiziente Methode dar, um auch mit solchen Precursoren, die einen niedrigen Dampfdruck, beziehungsweise einen hohen Siedepunkt aufweisen, hohe Massenflüsse zu erreichen.

Ein weiterer besonderer Vorzug der Erfindung liegt darin, dass gegenüber einem Bubbler die flüssige erste Prozessgaskomponente im Flüssigkeitsreservoir auf einer Temperatur unterhalb von 100°C, vorzugsweise unterhalb von 50°C, besonders bevorzugt ohne zusätzliche Heizung auf Umgebungstemperatur gelagert werden kann. Die Lagerung des Precursors bei Raumtemperatur führt dabei zu niedrigeren Produktionskosten und es werden unerwünschte Veränderungen des Precursors vermieden, die aufgrund einer längeren Heizung entstehen können. Das Flüssigkeitsreservoir kann sogar gekühlt werden. Beides erlaubt die Verwendung metastabiler Substanzen als Precursoren, welche bei der Verdampfungstemperatur im Verdampfer oder bei einer Temperatur von 130°C nicht dauerhaft stabil ist.

Insbesondere können Precursoren eingesetzt und präzise dosiert werden, die sowohl einen niedrigen Dampfdruck aufweisen, als auch metastabil sind. Mit einem Bubbler wäre dies nicht möglich, da der Precursor im Flüssigkeitsreservoir des Verdampfers längere Zeit auf der Verdampfungstemperatur gehalten wird.

Allgemein können nicht-zyklische Polyether, wie Mono-, Di-, Tri-, Tetra-, Penta- oder Hexaethylenglycol-dimethylether als erste Prozessgas-komponente verwendet werden.Ein Beispiel ist dabei die Flüssigdosierung von Tetraethylenglykol-Dimethyl-Ether ("Tetraglyme") als Precursor, beziehungsweise erste Prozessgaskomponente oder Bestandteil der Prozessgaskomponente. Diese Substanz weist einen relativ niedrigen Dampfdruck auf. Es wurde eine erfindungsgemäße Flüssigdosier-Vorrichtung eingesetzt, welche einen Massenflusssensor, ein mit einer elektronischen Regeleinrichtung gesteuertes Dosierventil, ein inertes Trägergas und ein Verdampfer verwendet, um den Precursor in die Gasphase zu überführen. Mittels dieser Vorrichtung wurden pharmazeutische Glas-Vials durch Plasmapolymerisation des Tetraethylenglykol-Dimethyl-Ethers innenbeschichtet. Die beschichteten Innenflächen der Vials zeigten dann eine sehr niedrige Protein-Adsorption verglichen mit unbeschichteten Glas-Vials. Mit Tetraethylenglykol-Dimethyl-Ether als Precursor kann dann eine Polyethylenglykol-haltige oder Polyethylenglykol-artige Beschichtung ("PEG-Beschichtung") auf dem Werkstück abgeschieden werden. Eine solche Schicht ist ein Beispiel für eine proteinabweisende, beziehungsweise proteinabstoßende Beschichtung. Im Bereich der Pharmaverpackungen ist besonderes Augenmerk auch auf derartige Beschichtungen gelegt. Proteine neigen an Glasoberflächen oft zur Denaturierung, was mit einer proteinabweisenden Beschichtung, wie etwa einer erfindungsgemäß herstellbaren PEG-Beschichtung vermieden oder zumindest erheblich verlangsamt werden kann. In derart beschichteten Pharmabehältern können daher empfindliche, proteinbasierte Medikamente, wie etwa Impfstoffe besser gelagert werden.

Allgemein können pharmazeutische oder medizintechnische Produkte, sowie Produkte für Diagnostikanwendungen zur Verbesserung der Funktionalität erfindungsgemäß beschichtet werden. Solche Produkte können Rohre, Pharma-Spritzen oder zugehörige Elastomerkomponenten, Karpulen oder Fläschchen sein. Im Falle von Produkten für Diagnostikanwendungen ist unter anderem an Microarrays gedacht.

Auch für die Abscheidung von Schichten aus Precursoren mit niedrigem Dampfdruck ergeben sich Vorteile. Diese Prozessgaskomponenten können aufgrund der Möglichkeit, das Reservoir auf niedriger Temperatur zu halten, einfacher gehandhabt werden.

Die Erfindung kann für Substrate aus Glas, Glaskeramik, Polymeren und Elastomeren, beispielsweise zur Beschichtung von Glasrohren oder Pharmaverpackungen verwendet werden. Als Beispiele für Pharmaverpackungen seien Vials, Karpulen Spritzenkörper, Gummistopfen oder elastomerbeschichtete Dichtungsflächen genannt. Auch für die Beschichtung von metallischen Oberflächen, wie etwa von Kanülen ist die Erfindung geeignet. Beschichtete Gegenstände können als vorteilhafte Eigenschaften dann erniedrigte Reibung und verbesserte Barrierewirkung aufweisen.

Ebenfalls können optische Funktionen realisiert werden, wie etwa optische Filterbeschichtungen, reflektierende Beschichtungen und Antireflexbeschichtungen und transparente Barriereschichten auf Beleuchtungselementen.

Nachfolgend sind mögliche vorteilhafte Eigenschaften von erfindungsgemäß herstellbaren Beschichtungen nochmals aufgelistet:
i) Modifizierung der Adsorption von Makromolekülen, vorzugsweise derart, dass die Makromoleküle abgewiesen oder abgestoßen werden,
ii) Veränderung der Reibung, beziehungsweise des Reibungskoeffizienten, vorzugsweise eine Erniedrigung der Reibung,
iii) Wirkung als Barrierebeschichtung gegen die Permeation von Gasen,
iv) Wirkung als Barrierebeschichtung gegen Auslaugung oder Extraktion von Bestandteilen des Substrats,
v) Wirkung als thermische Barriere,
vi) Anti-fouling-Wirkung,
vii) Reduzierte Adhäsion von Zellen,
viii) Anti-mikrobielle Wirkung,
ix) Haftvermittelnde, beziehungsweise haftungsverbessernde Eigenschaften,
x) Änderung der Oberflächenrauhigkeit, vorzugsweise eine Reduzierung der Oberflächenrauhigkeit,
xi) Veränderung der chemischen Eigenschaften der Oberfläche, insbesondere Erhöhung der chemischen Resistenz, beispielsweise gegen Anätzen,
xii) Schutz gegen Verkratzen,
xiii) Optische Funktionen, wie:
   - reflektierende oder
   - antireflektierende Wirkung,
   - Semitransparenz,
   - Transparenz,
   - Dekorative Effekte,
xiv) Leitfähige Beschichtungen mit höherer elektrischer oder thermischer Leitfähigkeit gegenüber dem Substrat.

Die verwendbaren Precursoren, beziehungsweise erste Prozessgaskomponenten können in folgende Gruppen unterteilt werden:
Gruppe I): Precursoren mit niedrigem Dampfdruck.
   Dazu gehören
   a) Polyether, wie das bereits genannte Tetraethylenglykol-Dimethyl-Ether für proteinabweisende Beschichtungen auf Vials, Spritzen und Kartuschen, sowie
   b) Metallorganische Precursoren für Barrierebeschichtungen, beispielsweise auf Vials, Spritzen und Kartuschen, sowie für optisch funktionelle Beschichtungen.
Gruppe II): Precursoren mit mittlerem und hohem Dampfdruck.
   Dazu gehören
   a) Organo-Silizide wie HMDSO, TMDSO,
   b) Metall-Halogenide, beispielsweise für optisch funktionelle Beschichtungen oder Barrierebeschichtungen, Beschichtungen, wie TiCl₄ SiCl₄
   c) Siloxane, wie APS, DETA.

Die Erfindung wird nachfolgend anhand von Ausführungsbeispielen und unter Bezugnahme auf die beigeschlossenen Zeichnungen näher erläutert.

Es zeigen:
Fig. 1 einen schematischen Aufbau einer erfindungsgemäßen Beschichtungsvorrichtung,
Fig. 2 ein Diagramm der Fibrinogen-Adsorption an ein erfindungsgemäß hergestellten Polyethylenglykol-Beschichtungen,
Fig. 3 Messwerte des Kontaktwinkels von Wasser an erfindungsgemäß hergestellten Polyethylenglykol-Beschichtungen,
Fig. 4 ein Ausführungsbeispiel eines Gaserzeugers.

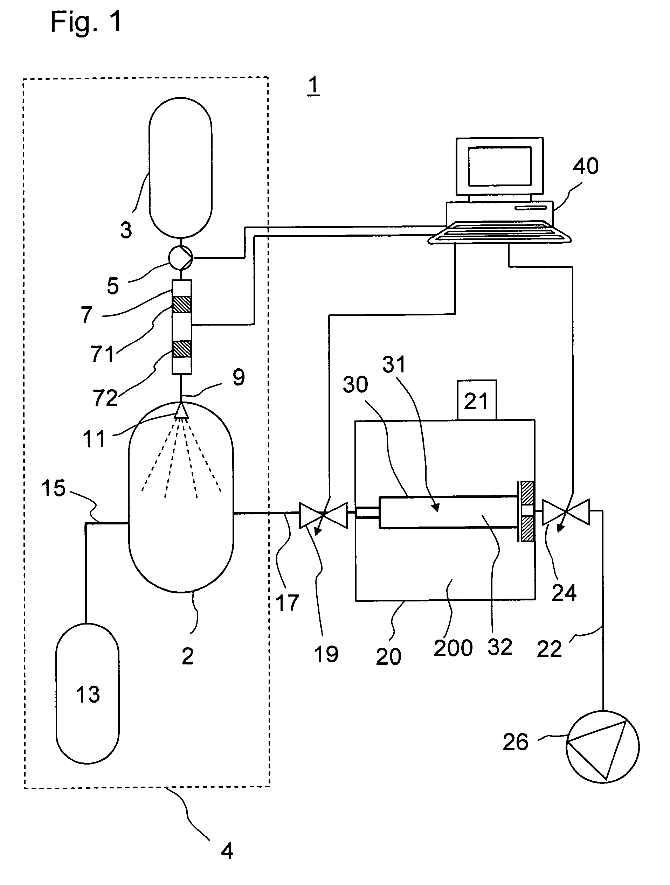

In Fig. 1 ist der Aufbau einer Vorrichtung 1 zur plasmaunterstützten CVD-Beschichtung von Werkstücken dargestellt. Das grundlegende Prinzip dieser Vorrichtung basiert darauf, dass eine Schicht auf einem Werkstücken abgeschieden wird, indem wenigstens eine Komponente zur Herstellung der Schicht dosiert wird, wobei sich diese Komponente während der Dosierung in einer flüssigen Phase befindet und in einem nachfolgenden Prozessschritt zumindest teilweise in einen anderen Aggregatzustand überführt wird.

Die Vorrichtung 1 umfasst als zentralen Bestandteile einen Reaktor 20 und einen Gaserzeuger 4 mit einem Verdampfer 2.Der Gaserzeuger 4 umfasst weiterhin ein Flüssigkeitsreservoir 3 mit einer flüssigen ersten Prozessgaskomponente. Eine Fluidfördereinrichtung 5 fördert die flüssige erste Prozessgaskomponente durch eine Zuleitung 9 zu einer Düse 11 im Verdampfer 2. Als Fluidfördereinrichtung kann beispielsweise auch eine Druckbeaufschlagung des Reservoirs 3 dienen. In der Düse 11 wird die flüssige erste Prozessgaskomponente versprüht, um eine schnelle Verdampfung durch Bildung kleiner Tropfen zu erreichen.

Über eine weitere Zuleitung 15 wird ein Inertgas als zweite Prozessgaskomponente aus einem Behälter 13 in den Verdampfer 2 geleitet und dort mit der verdampften ersten Prozessgaskomponente gemischt und damit das zur Schichtabscheidung verwendete Prozessgas hergestellt. Je nach abzuscheidender Schicht und Precursor kann alternativ oder zusätzlich auch ein Reaktivgas zugeführt werden.

Im Innenraum 200 des Reaktors 20 wird ein Werkstück 30 angeordnet. Das Werkstück 30, hier beispielhaft ein Spritzenkörper, ist hohlkörperförmig und soll innenseitig beschichtet werden. Dazu wird der Innenraum 31 des Werkstücks 30 an eine Ableitung 22 zu einer Pumpe 26 angeschlossen und evakuiert. Ist die Wandung des Werkstücks 30 hinreichend stark, kann die Umgebung des Werkstücks auch auf Normaldruck verbleiben. Anderenfalls wird auch die Umgebung so weit evakuiert, dass die Druckdifferenz an die mechanische Belastbarkeit des Werkstücks angepasst ist und, sofern außen kein Plasma gezündet werden soll, der Druck für eine Zündung des Plasmas entweder zu klein oder zu groß ist.

Das im Verdampfer 2 erzeugte Prozessgas mit der ersten und zweiten Prozessgaskomponente wird dem evakuierten Bereich des Reaktor 20, also dem Innenraum 31 des Werkstücks 30 zugeführt. Eine Energiequelle, beispielsweise eine Mikrowellenquelle 21 erzeugt ein elektromagnetisches Feld, welches in den Innenraum 200 des Reaktors eingestrahlt wird. Mittels des elektromagnetischen Feldes wird ein Plasma im evakuierten, mit dem Prozessgas gefüllten Bereich des Reaktors gezündet, wobei mit den sich im Plasma bildenden Reaktionsprodukten der ersten Prozessgaskomponente eine Beschichtung auf dem Werkstück 30 abgeschieden wird. Der Innenraum 31 bildet dementsprechend eine reaktive Zone 32, in welcher Reaktionsprodukte erzeugt werden, welche sich als Beschichtung auf dem Werkstück niederschlagen. Alternativ zu einer Mikrowellenquelle kann auch eine Mittelfrequenz- oder Radiofrequenzquelle zum Erzeugen des Plasmas verwendet werden.

Der Beschichtungsprozess wird mittels einer Regeleinrichtung 40 gesteuert, indem der Massenfluss der ersten Prozessgaskomponente in den Reaktor hinein mittels einer eine Regelung des Flusses der flüssigen Prozessgaskomponente in den Verdampfer geregelt wird. Typische Massenflüsse liegen dabei im Bereich von 0,0005 bis 2000 g/h, vorzugsweise im Bereich von 0,05 g/h bis 50 g/h, besonders bevorzugt im Bereich von 0,1 g/h bis 20 g/h. Für die korrespondierenden Volumenströme liegen typische Bereiche zwischen 5nl/min bis 1000µl/min, vorzugsweise zwischen 10 nl/min bis 100µl/min, besonders bevorzugt zwischen 20 nl/min bis 10µl/min.

Eine Regelung des Drucks im Beschichtungsbereich erfolgt über eine von der Regeleinrichtung 40 gesteuerte Drossel 24 in der Ableitung 22 zur Pumpe 26.

Es ist zweckmäßig, auch ein Ventil 19 in der Zuleitung 17 vom Verdampfer 2 zum Reaktor 20 vorzusehen, dass auch, wie im gezeigten Beispiel von der Regeleinrichtung 40 gesteuert werden kann. Damit kann beim Entnehmen und Einsetzen der Werkstücke 30 und beim der Beschichtung vorgeordneten Evakuieren der Verdampfer abgesperrt werden. Eine Regelung des Massenflusses der ersten Prozessgaskomponente, beziehungsweise des im Verdampfer hergestellten Prozessgases erfolgt hier jedoch vorzugsweise nicht. Das Ventil 19 kann daher einfach als Schaltventil ausgebildet sein.

Dazu wird der Fluss mittels eines Massenflusssensors 7 in der Zuleitung 9 gemessen und die Messwerte an die Regeleinrichtung 40 übermittelt. Der Massenflusssensor 7 umfasst zwei Temperaturfühler 71, 72, die entlang der Flussrichtung in der Zuleitung 9 beabstandet angeordnet sind und mit denen ein Temperaturgradient gemessen wird. Eine Heizquelle ist vorgesehen, um lokal Wärme zuzuführen und so einen Temperaturgradienten entlang der Flussrichtung zu erzeugen. Beispielsweise können die Temperaturfühler 71, 72 dazu als strombeheizte Widerstandselemente ausgebildet sein. Der Sollwert wird durch Steuerung der Fluidfördereinrichtung 5 eingestellt. Alternativ oder zusätzlich kann dazu auch ein Regelventil vorgesehen sein. Dies ist beispielsweise dann sinnvoll, wenn die flüssige erste Prozessgaskomponente durch eine Druckbeaufschlagung des Reservoirs 3 in den Verdampfer 2 gefördert wird.

Auch die Energiequelle, im dargestellten Beispiel also die Mikrowellenquelle 21 wird von der Regeleinrichtung angesteuert, um unter anderem die Start- und Endzeitpunkte des Abscheidevorgangs zu steuern.

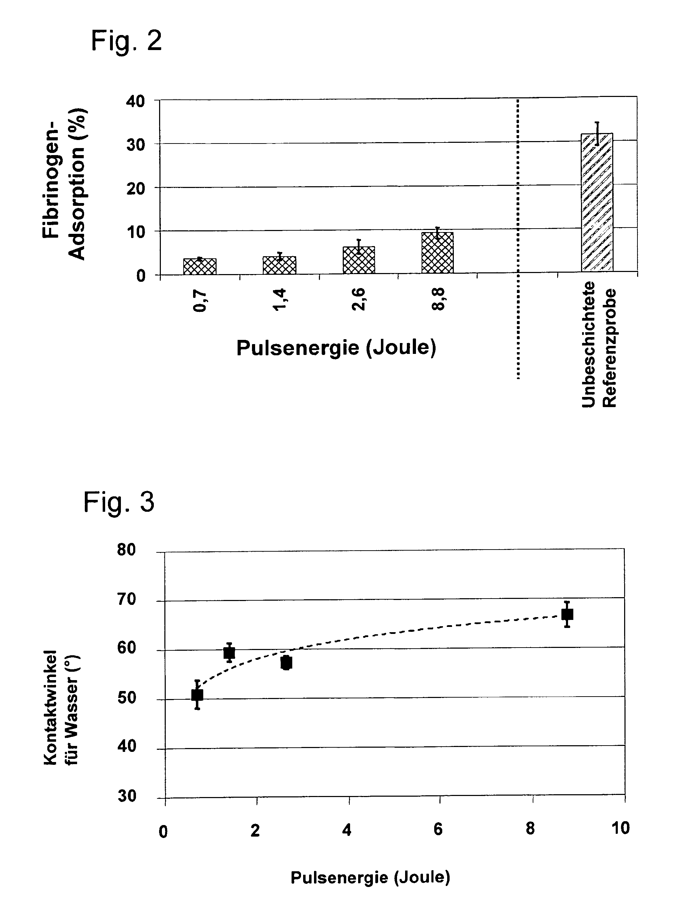

Fig. 2 und Fig. 3 zeigen Eigenschaften von pharmazeutischen Glas-Vials, die mit proteinabweisenden Beschichtungen mittels des erfindungsgemäßen Verfahrens beschichtet wurden.

Die Beschichtungen wurden durch CVD-Abscheidung mit Tetraethylenglykol-Dimethyl-Ether als Prozessgaskomponente abgeschieden, wobei die erfindungsgemäße Flüssigdosierung verwendet wurde. Der Precursor wurde dabei im Reservoir bei Raumtemperatur gelagert. Die Abscheidung geschah durch Plasmapolymerisation in einem gepulsten Plasma.

Fig. 2 zeigt dabei in einem Diagramm Messwerte der Fibrinogen-Adsorption auf proteinabweisenden Polyethylenglykol-Beschichtungen, sowie einen Referenzwert an einem unbeschichteten Vial. Die Beschichtungen wurden mit verschiedenen Pulsenergien im Bereich zwischen 0,7 und 8,8 Joule abgeschieden.

Anhand von Fig. 2 ist zu erkennen, dass eine deutliche Reduktion der Proteinadsorption mit den erfindungsgemäß abgeschiedenen Beschichtungen erzielt werden kann.

Fig. 3 zeigt den Kontaktwinkel für Wasser an den beschichteten Vials.

Anhand beider Figuren ist eine deutliche Abhängigkeit von der Pulsenergie zu erkennen. Die Fibrinogen-Adsorption steigt mit steigender Pulsenergie. Der Kontaktwinkel steigt ebenfalls. Der Kontaktwinkel für Wasser variiert dabei von 51° bei einer niedrigen Pulsenergie von 0,7 Joule bis zu einem Winkel von 66,7° bei einer Pulsenergie von 8,75 Joule. Schichten, die mit niedrigeren Energien abgeschieden wurden, weisen demnach hydrophilere Eigenschaften auf, die zur niedrigen Proteinadsorption beitragen.

Allgemein ist gemäß einer Weiterbildung der Erfindung daher unter Berücksichtigung der obigen Resultate vorgesehen, dass ein gepulstes Plasma eingesetzt wird, um proteinabweisende Polyethylenglykol-Beschichtungen oder Polyethylenglykol-artige Beschichtungen oder Schichten mit Tetraethylenglykol-Dimethyl-Ether als Prozessgaskomponente abzuscheiden, wobei eine niedrige Pulsenergie eingesetzt wird, wobei die Pulsenergie 3 Joule nicht überschreitet.

Gepulste Plasmen werden dabei allgemein, ohne Beschränkung auf die vorstehenden Beispiele bevorzugt.

Die Herstellung der Proben, auf welche sich die Fig. 2 und 3 beziehen, wird nachfolgend als Ausführungsbeispiel näher erläutert.

Der flüssige Precursor Tetraethylenglykol-Dimethyl-Ether wird bei Raumtemperatur in einem abgeschlossenen Behälter gelagert und mit Druck durch ein Inertgas beaufschlagt. In diesem Zusammenhang ist als Inertgas jedes Gas geeignet, welches nicht oder nicht in wesentlichem Masse im Reservoir mit der flüssigen ersten Prozessgaskomponente reagiert.

Der Precursor fließt in das Flüssigdosiersystem, wobei der Fluss mit einem thermischen Massenflusssensor mit

Thermopaaren als Temperatursensoren gemessen wird. Mit einem anschließenden Regelventil wird der Sollwert des Massenflusses eingestellt. Der Precursor bleibt während dieses Dosiervorgangs flüssig. Argongas wird in den Verdampfer geleitet und dient als Trägergas. Das Argongas bildet zusammen mit dem Precursor dann das bei der Abscheidung verwendete Prozessgas. Zwei Glas-Vials mit 10 Millilitern Gesamtvolumen werden in einen Doppelkammer-Reaktor eingesetzt und gleichzeitig bis auf einen Basisdruck kleiner 0,1 mBar evakuiert.

Der Massenfluss des Tetraethylenglykol-Dimethyl-Ethers wird mittels des Regelventils auf 0,95 Gramm/Stunde eingestellt. Für das Trägergas wird parallel ein Fluss von 1,6sccm eingestellt, so dass nach der Verdampfung eine Precursor-Konzentration von 52 Volumenprozent im Prozessgas vorliegt.

Nach einem ersten Aufheiz- und Vorbehandlungsschritt werden die Vials auf eine Prozesstemperatur von 120°C mittels eines Argon-Plasmas aufgeheizt. Das Plasma wird mit einer gepulsten Mikrowellenquelle mit einer Mikrowellenfrequenz von 2,45 GHz und einer mittleren Leistung von 250 Watt pro Vial aufrechterhalten. Dabei werden ein Argon-Massenfluss von 50sccm pro Vial und ein Prozessdruck von 0,2mbar eingestellt.

In einem zweiten Schritt direkt nach dem Aufheizen wird das Prozessgas aus dem Verdampfer in den Reaktor, beziehungsweise in die darin angeordneten Vials eingeleitet, wobei ein Prozessgasdruck von 0,2 mbar eingestellt wird.

Die Leistung der Mikrowellenquelle bei gleicher Frequenz von 2,45 GHz wird in die beiden Kammern des Reaktors aufgeteilt und es wird ein Plasma im Prozessgas in den beiden Vials gezündet.

Vier verschiedene Pulsenergien entsprechend der in den Fig. 2 und 3 gezeigten Messwerte wurden für die Plasmapolymerisation verwendet. Die Verfahrensparameter sind in der nachstehenden Tabelle angegeben:

| Serie Nr. | Beschichtung, Nr. | Pulsenergie (Joule) | Anzahl von Proben |
|---|---|---|---|
| 1 | layer1 | 0,7 | 14 |
| 2 | layer2 | 1,4 | 14 |
| 3 | layer3 | 2,6 | 14 |
| 4 | layer4 | 8,8 | 14 |

Bei allen Abscheidungen wurden Beschichtungen mit einer Dicke von etwa 50 Nanometern auf der Innenseite der Vials hergestellt.

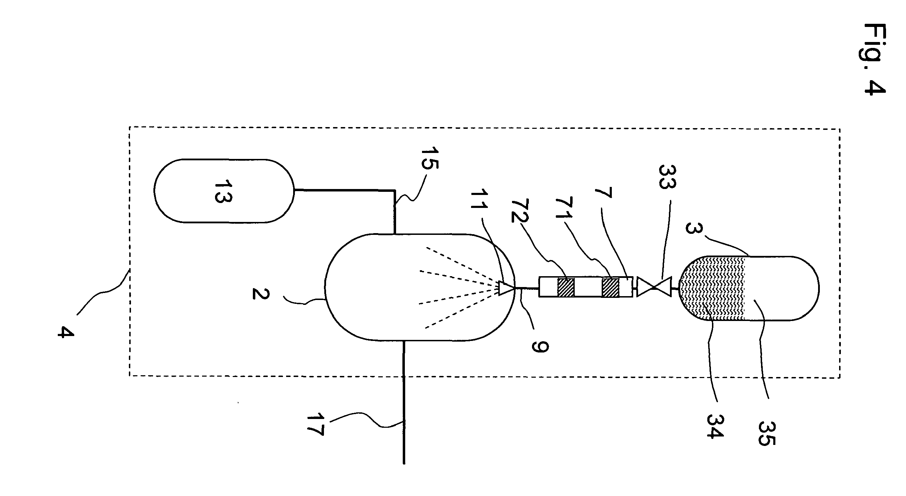

Fig. 4 zeigt eine Ausgestaltung eines Gaserzeugers 4, wie er anstelle des in Fig. 1 gezeigten Gaserzeugers verwendet werden kann.

Bei dieser Ausführungsform ist keine Fluidfördereinrichtung 5 vorgesehen. Anstelle dessen wird das Reservoir 3 unter Druck gesetzt, indem in das Reservoir ein Inertgas 35 eingefüllt wird, bis im Behälter ein gewisser Überdruck herrscht. Die flüssige erste Prozessgaskomponente 34 strömt dann aufgrund des Überdrucks durch die Leitung 9 zur Düse 11. Die Regelung des Massenflusses geschieht hier über ein Regelventil 33, welches an der Regeleinrichtung 40 angeschlossen ist und von der Regeleinrichtung 40 gesteuert wird.

## Patentansprüche

1. Verfahren zur Dampfphasenabscheidung von Schichten auf Werkstücken (30), wobei
- ein Flüssigkeitsreservoir (3) mit einer flüssigen ersten Prozessgaskomponente (34) bereitgestellt wird, und
- die flüssige Prozessgaskomponente (34) über eine Dosiereinrichtung (5, 33) in einen Verdampfer (2) geleitet wird, wobei
- die flüssige erste Prozessgaskomponente (34) im Verdampfer (2) verdampft und in die Gasphase überführt wird,
- die gasförmige erste Prozessgaskomponente einem Reaktor (20) zugeführt wird, und
- mittels einer Energiequelle (21) eine reaktive Zone (32) mit der ersten Prozessgaskomponente im gefüllten Bereich des Reaktors (20) erzeugt wird, wobei
- mit den sich in der reaktiven Zone (32) bildenden Reaktionsprodukten der ersten Prozessgaskomponente eine Beschichtung auf dem Werkstück (30) abgeschieden wird, und
- der Massenfluss der ersten Prozessgaskomponente (34) in den Reaktor (20) hinein mittels einer auf die Dosiereinrichtung (5, 33) wirkenden Regeleinrichtung (40) durch eine Regelung des Flusses der flüssigen Prozessgaskomponente (34) in den Verdampfer (2) gesteuert wird,
**dadurch gekennzeichnet, dass** der Fluss der flüssigen Prozessgaskomponente (34) in deren Zuleitung (9) zum Verdampfer (2) mit einem Massenflusssensor (7) gemessen wird, der zwei entlang der Flussrichtung in der Zuleitung angeordnete Temperaturfühler (71, 72) umfasst, mit denen ein Temperaturgradient in der flüssigen Prozessgaskomponente (34) gemessen wird.

2. Verfahren nach vorstehendem Anspruch zur plasmaunterstützten Dampfphasenabscheidung von Schichten auf Werkstücken (30), wobei
- ein Reaktor (20) mit einem zu beschichtenden Werkstück (30) mittels einer Pumpe (26) evakuiert wird,
- die gasförmige erste Prozessgaskomponente dem evakuierten Bereich des Reaktors (20) zugeführt wird, und
- mittels eines elektromagnetischen Feldes ein vorzugsweise gepulstes Plasma im evakuierten, mit der ersten Prozessgaskomponente gefüllten Bereich des Reaktors (20) gezündet wird, wobei
- mit den sich im Plasma bildenden Reaktionsprodukten der ersten Prozessgaskomponente eine Beschichtung auf dem Werkstück (30) abgeschieden wird.

3. Verfahren gemäß vorstehenden Ansprüchen, **dadurch gekennzeichnet, dass** die Dosiergenauigkeit des Flüssigkeitsvolumenstroms
im Bereich unterhalb von 30pl/min,
vorzugsweise im Bereich unterhalb von 3pl/min, besonders bevorzugt unterhalb von 0,3pl/min liegt.

4. Verfahren gemäß einem der vorstehenden Ansprüche,
**dadurch gekennzeichnet, dass**
- die Verdampfungsrate der flüssigen Prozessgaskomponente (34) im Verdampfer (2) höher eingestellt wird, als der Zufluss der flüssigen Prozessgaskomponente (34), um eine Verzögerung der Regelung über die Flüssigdosierung zu reduzieren, und/oder
- die flüssige erste Prozessgaskomponente mit einer Düse im Verdampfer versprüht wird.

5. Verfahren gemäß einem der vorstehenden Ansprüche,
**dadurch gekennzeichnet, dass**
- ein Gemisch aus wenigstens zwei Komponenten flüssig dosiert wird, um eine Abhängigkeit des Mengenverhältnisses der Komponenten vom Dampfdruck zu reduzieren, und/oder
- die Prozessgas-Menge im Reaktor (20) durch eine Regelung des Drucks im Reaktor (20) und des Massenflusses geregelt wird.

6. Verfahren gemäß einem der vorstehenden Ansprüche,
**dadurch gekennzeichnet, dass**
ein Polyether als Bestandteil der ersten Prozessgaskomponente (34), vorzugsweise ein nichtzyklischer Polyether, insbesondere bevorzugt ein Mono-, Di-, Tri-, Tetra-, Penta- oder Hexaethylenglycol-dimethylether verdampft wird,
vorzugsweise Tetraethylenglykol-Dimethyl-Ether als Bestandteil der ersten Prozessgaskomponente (34) verdampft wird und
eine Polyethylenglykol-haltige oder Polyethylenglykol-artige Beschichtung auf dem Werkstück (30) abgeschieden wird,
wobei eine Pulsenergie eingesetzt wird, die 3 Joule nicht überschreitet.

7. Verfahren gemäß einem der vorstehenden Ansprüche, **dadurch gekennzeichnet, dass** mittels einer gegenüber einem Vergleichswert niedrigeren Pulsenergie eine Schicht abgeschieden wird, die hydrophilere Eigenschaften aufweist oder zu einer niedrigeren Proteinadsorption beiträgt als eine Schicht, die mittels einer Pulsenergie in Höhe des Vergleichswerts abgeschieden wird.

8. Vorrichtung (1) zur Abscheidung von Schichten auf Werkstücken (30), umfassend
- ein Flüssigkeitsreservoir (3) für eine flüssige erste Prozessgaskomponente (34),
- eine Dosiereinrichtung (5,33)
- einen Verdampfer (2),
- eine Leitung, um die flüssige Prozessgaskomponente (34) in den Verdampfer (2) zu leiten,
- ein Reaktor (20), ausgebildet zur Aufnahme eines zu beschichtenden Werkstücks (30),
- eine am Reaktor (20) angeschlossene Gasabführung (22), über die flüchtige Zersetzungsprodukte aus dem Beschichtungsbereich des Reaktors (20) entfernt werden können,
- eine Zuleitung (17), um die im Verdampfer (2) verdampfte gasförmige erste Prozessgaskomponente dem Reaktor (20) zuzuführen,
- eine Energiequelle (21) welche an den Reaktor (20) angeschlossen ist, um eine reaktive Zone im mit der ersten Prozessgaskomponente gefüllten Bereich des Reaktors (20) zu erzeugen, so dass mit den sich in der reaktiven Zone bildenden Reaktionsprodukten der ersten Prozessgaskomponente eine Beschichtung auf dem Werkstück (30) abgeschieden wird, und
- eine Regeleinrichtung (40) zur Regelung des Massenflusses der ersten Prozessgaskomponente in den Reaktor (20) hinein, wobei die Regeleinrichtung (40) dazu ausgebildet ist, zur Einstellung des Massenflusses den Fluss der flüssigen Prozessgaskomponente (34) in den Verdampfer (2) über die Dosiereinrichtung (5,33) zu regeln, **gekennzeichnet durch** einen in der Zuleitung (9) zum Verdampfer (2) angeordneten Massenflusssensor (7), der zwei entlang der Flussrichtung in der Zuleitung angeordnete Temperaturfühler (71, 72) umfasst, mit denen ein Temperaturgradient in der flüssigen Prozessgaskomponente (34) gemessen wird.

9. Vorrichtung (1) nach vorstehendem Anspruch zur plasmaunterstützten Dampfphasenabscheidung von Schichten auf Werkstücken (30), umfassend
- ein Flüssigkeitsreservoir (3) für eine flüssige erste Prozessgaskomponente (34),
- eine Dosiereinrichtung (XX)
- einen Verdampfer (2),
- eine Leitung, um die flüssige Prozessgaskomponente (34) in den Verdampfer (2) zu leiten,
- ein Reaktor (20), ausgebildet zur Aufnahme eines zu beschichtenden Werkstücks (30),
- eine am Reaktor (20) angeschlossene Pumpe (26), um den Beschichtungsbereich des Reaktors (20) zu evakuieren,
- eine Zuleitung (17), um die im Verdampfer (2) verdampfte gasförmige erste Prozessgaskomponente dem Reaktor (20) zuzuführen, und
- eine Quelle (21) für elektromagnetische Felder, welche an den Reaktor (20) angeschlossen ist, um mittels des von der Quelle erzeugten elektromagnetischen Feldes ein Plasma im evakuierten, mit der ersten Prozessgaskomponente gefüllten Bereich des Reaktors (20) zu zünden, so dass mit den sich im Plasma bildenden Reaktionsprodukten der ersten Prozessgaskomponente eine Beschichtung auf dem Werkstück (30) abgeschieden wird,
- eine Regeleinrichtung (40) zur Regelung des Massenflusses der ersten Prozessgaskomponente in den Reaktor (20) hinein, wobei die Regeleinrichtung (40) dazu ausgebildet ist, zur Einstellung des Massenflusses den Fluss der flüssigen Prozessgaskomponente (34) in den Verdampfer (2) zu regeln,
**gekennzeichnet durch** einen in der Zuleitung (9) zum Verdampfer (2) angeordneten Massenflusssensor (7), der zwei entlang der Flussrichtung in der Zuleitung angeordnete Temperaturfühler (71, 72) umfasst, mit denen ein Temperaturgradient in der flüssigen Prozessgaskomponente (34) gemessen wird.

10. Beschichtung, die mit einem Verfahren nach einem der Ansprüche 1 bis 7, insbesondere nach einem der Ansprüche 2 bis 7, erzeugt wurde, wobei vorzugsweise die Beschichtung Polyethylenglykol-haltig oder Polyethylenglykol-artig ist.
